# EUROPEAN PATENT APPLICATION

(11) **EP 4 755 725 A1**
(43) Date of publication of application: **10.06.2026**
(21) Application number: 25213694.0
(22) Date of filing: 05.11.2025
(51) Int. Cl.: B60R 16/023

(54) **INTEGRATED ELECTRONIC CONTROL UNIT, INTEGRATED ELECTRONIC CONTROL UNIT MOUNTING STRUCTURE, AND VEHICLE**

(30) Priority: 06.12.2024 JP 2024214016
(71) Applicant: TOYOTA JIDOSHA KABUSHIKI KAISHA, Toyota-shi, Aichi-ken 471-8571 (JP)
(72) Inventor: TAKATA, Kazunori, Toyota-shi, 471-8571 (JP); TERADA, Yoshiki, Toyota-shi, 471-8571 (JP)
(74) Representative: J A Kemp LLP

(57) **Abstract**

An integrated electronic control unit that is installed to a vehicle, and that aggregates and is connected by control function to plural electronic control units installed to the vehicle. The integrated electronic control unit is mounted to a partition wall positioned between a cabin and a drive section of the vehicle so as to face another integrated electronic control unit across the partition wall, and such that at least a part of the integrated electronic control unit overlaps with the other integrated electronic control unit when looking in a vehicle forward direction.

## Description

### BACKGROUND

### Technical Field

Technology disclosed herein relates to an integrated electronic control unit, an integrated electronic control unit mounting structure, and a vehicle.

### Related Art

In order to implement control of each vehicle section in a vehicle, plural individual electronic control units (ECUs) are installed to execute the control. Moreover, particularly in such fields as battery electric vehicles (BEV) and hybrid electric vehicles (HEV), sometimes there are cases in which an integrated electronic control unit (also called an "integrated ECU" or a "domain controller") that aggregates and is connected to plural ECUs is employed to perform integrated control of the plural ECUs. For example, Japanese Patent No. 7358472 describes performing control of a vehicle using plural domain controllers.

### SUMMARY

Such domain controllers need to be connected to plural ECUs and another domain controller, a power source, and the like. Making a wiring length of wiring, such as a wire harness or the like, employed to perform such connection short is important from the perspectives of reducing vehicle weight and reducing production cost. There is further room for improvement in a structure including a domain controller from such perspectives.

In consideration of the above circumstances, the present disclosure provides an integrated electronic control unit, an integrated electronic control unit mounting structure, and a vehicle that enable a wiring length needed for connection to be shortened.

An integrated electronic control unit according to a first aspect is installed to a vehicle, aggregates and is connected by control function to plural electronic control units installed to the vehicle, and is mounted to a partition wall positioned between a cabin and a drive section of the vehicle so as to face another integrated electronic control unit across the partition wall, and such that at least a part of the integrated electronic control unit overlaps with the other integrated electronic control unit when looking in a vehicle forward direction.

The above integrated electronic control unit is arranged so as to overlap with the other integrated electronic control unit when looking in the vehicle forward direction, and due to a distance between the two integrated electronic control units being close, the wiring length of wiring connecting between the two integrated electronic control units can be made short.

An integrated electronic control unit according to a second aspect is the integrated electronic control unit of the first aspect, wherein the integrated electronic control device is mounted at a position adjacent to a through hole provided in the partition wall through which wiring is routed.

In the above integrated electronic control unit, the distance between the through hole and the integrated electronic control unit can be made short, enabling a shorter wiring length of the wiring connecting between the through hole and the integrated electronic control unit.

An integrated electronic control unit according to a third aspect is the integrated electronic control unit of the first or second aspect including a controller main body, and a connector configured for connecting the wiring to and provided to a face of the controller main body adjacent to a through hole provided in the partition wall for routing wiring through, or provided to a face of the controller main body on the opposite side to the face facing the partition wall.

In the above integrated electronic control unit, the connector is installed at a position comparatively close to the through hole of the controller main body, thereby enabling a short wiring length of wiring connecting between the through hole and the integrated electronic control unit.

An integrated electronic control unit mounting structure according to a fourth aspect includes a partition wall that is positioned between a cabin and a drive section of a vehicle, a first integrated electronic control unit that is mounted to the drive section side of the partition wall, and that aggregates and is connected to plural first electronic control units having a prescribed control function installed to the vehicle, and a second integrated electronic control unit that is mounted to the cabin side of the partition wall, and that aggregates and is connected to plural second electronic control units installed to the vehicle and having another prescribed control function different to the prescribed control function. The first integrated electronic control unit and the second integrated electronic control unit are respectively mounted to the partition wall such that at least a part of the integrated electronic control units overlap when looking in a vehicle forward direction.

In the above integrated electronic control unit mounting structure, the distance between the first and second integrated electronic control units can be made short, enabling a short wiring length of the wiring connecting the two integrated electronic control units together.

An integrated electronic control unit mounting structure according to the fifth aspect is the integrated electronic control unit mounting structure of the third aspect, wherein at least one out of the first integrated electronic control unit or the second integrated electronic control unit is mounted at a position adjacent to a through hole provided in the partition wall through which wiring is routed.

In the above integrated electronic control unit mounting structure, a distance between the through hole and the first and/or second integrated electronic control unit can be made short, enabling a shorter wiring length of the wiring connecting between the through hole and the first and/or second integrated electronic control unit.

An integrated electronic control unit mounting structure according to a sixth aspect is the integrated electronic control unit mounting structure of the fourth or fifth aspect, wherein the first integrated electronic control unit and the second integrated electronic control unit each include a controller main body, and a connector that is provided to the controller main body on a face of adjacent to a through hole provided in the partition wall through which wiring is routed, or on a face on the opposite side to a face facing toward the partition wall, with the wiring connected to the connector.

In the above integrated electronic control unit mounting structure, the connector is installed at a position comparatively near to the through hole of the controller main body, enabling a short wiring length of wiring connecting between the through hole and the first and second integrated electronic control units.

An integrated electronic control unit mounting structure according to a seventh aspect is the integrated electronic control unit mounting structure of any one from the fourth to sixth aspects, wherein the other prescribed control function includes a driving assist function, and the prescribed control function includes a function other than the driving assist function.

In the above integrated electronic control unit mounting structure, the first and second integrated electronic control units are arranged to match the arrangement of the first and second electronic control units, enabling a wiring length of wiring between the integrated electronic control units and the electronic control units to be suppressed to a short length.

A vehicle according to an eighth aspect includes a partition wall that is positioned between a cabin and a drive section, a first integrated electronic control unit that is mounted to the drive section side of the partition wall, and that aggregates and is connected to plural first electronic control units having a prescribed control function, and a second integrated electronic control unit that is mounted to the cabin side of the partition wall, and that aggregates and is connected to plural second electronic control units having another prescribed control function different to the prescribed control function. The first integrated electronic control unit and the second integrated electronic control unit are respectively mounted to the partition wall such that at least part of the integrated electronic control units overlap when looking in a vehicle forward direction.

In the above vehicle, the distance between the first and second integrated electronic control units can be made short, enabling a short wiring length of the wiring connecting the two integrated electronic control units together.

### BRIEF DESCRIPTION OF THE DRAWINGS

Exemplary embodiments of the present invention will be described in detail based on the following figures, wherein:
Fig. 1 is a schematic side view illustrating an example of a vehicle according to an exemplary embodiment;
Fig. 2 is a perspective view illustrating an example of a cabin front structure including the partition wall illustrated in Fig. 1;
Fig. 3 is a block diagram schematically illustrating a connection structure of first and second domain controllers;
Fig. 4 is a diagram illustrating the cabin front structure illustrated in Fig. 2 as viewed from a vehicle front section side;
Fig. 5 is a diagram illustrating the cabin front structure illustrated in Fig. 2 as viewed from a cabin side;
Fig. 6 is an enlargement illustrating part of the cabin front structure illustrated in Fig. 2 as viewed from above.

### DETAILED DESCRIPTION

The present disclosure will become more fully understood from the detailed description given hereinbelow. Further range of application of the present disclosure will become clearer from the detailed description given hereinbelow. However, the detailed description and the specific embodiment are illustrated of desired embodiments of the present disclosure and are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Like reference numbers and designations in the various drawings indicate like elements.

Description follows regarding exemplary embodiments to execute technology disclosed herein, with reference to the drawings. Note that the following description schematically illustrates a scope needed to explain achieving an object of the present disclosure, and mainly describes a scope needed to explain such sections of the present disclosure, with parts omitted from the description being known technology. Moreover, the same or similar reference numerals are appended across the drawings to members that are the same or equivalent, and detailed explanation thereof will be omitted. Furthermore, when there are plural of the same or equivalent members present in the drawings, sometimes reference numerals are appended to only some thereof in order to facilitate reading of the drawings.

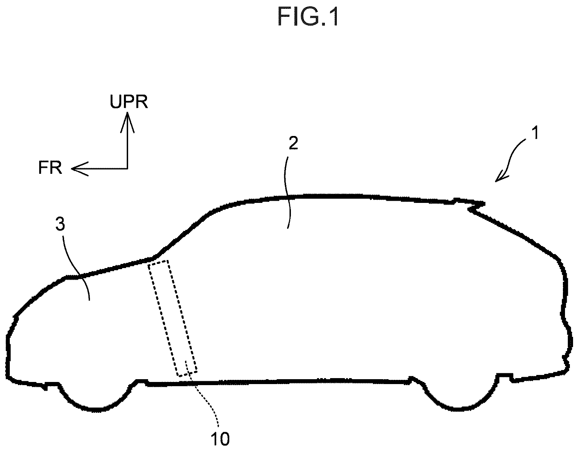

Fig. 1 is a schematic side view illustrating an example of a vehicle according to an exemplary embodiment of the present disclosure. As illustrated in Fig. 1, a vehicle 1 according to the present exemplary embodiment includes a cabin front structure 10 that partitions between a cabin 2 where occupants ride, and a vehicle front section 3 serving as an example of a drive section configuring an engine room, or a housing space or the like for housing a battery or the like. Note that in Fig. 1 arrow FR indicates forward for the vehicle 1, and arrow UPR indicates upward for the vehicle 1. Moreover, the cabin front structure 10 is an example of an "integrated electronic control unit mounting structure".

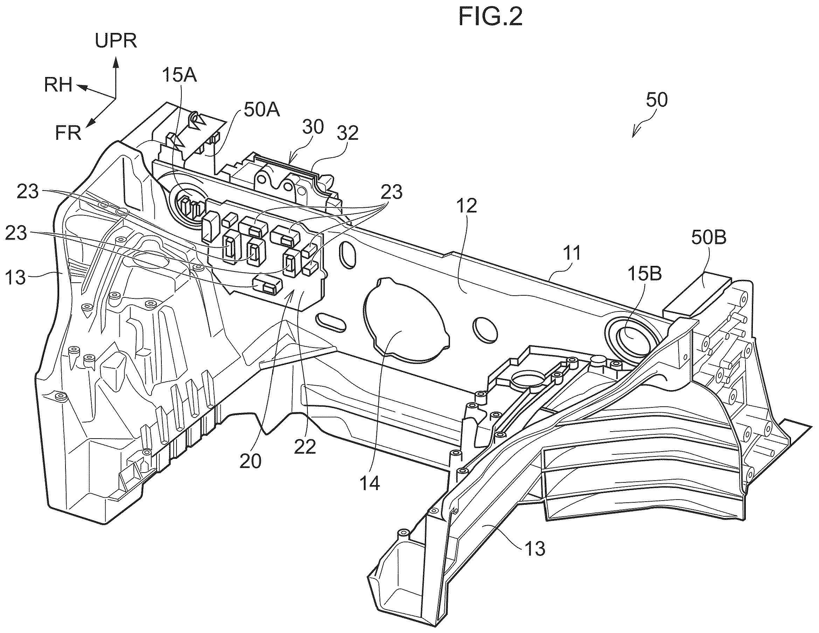

Fig. 2 is a perspective view illustrating an example of a cabin front structure including the partition wall illustrated in Fig. 1. As illustrated in Fig. 2, the cabin front structure 10 includes a partition wall 11 positioned between the cabin 2 and the vehicle front section 3, and first and second domain controllers 20, 30 mounted to the partition wall 11. Note that arrow RH in Fig. 2 indicates a right direction for the vehicle 1. The first domain controller 20 is an example of a "first integrated electronic control unit", and the second domain controller 30 is an example of a "second integrated electronic control unit". Moreover, one or other out of the first or second domain controllers 20, 30 is an example of an "integrated electronic control unit", and the other thereof is an example of "another integrated electronic control unit". Moreover, wiring 40 routed at the periphery of the partition wall 11 is omitted from illustration in Fig. 2.

The partition wall 11 is a member partitioning between the cabin 2 and the vehicle front section 3 and, for example, may be configured by at least part of a dash panel. The partition wall 11 may be configured from a molded product made from metal configuring part of a vehicle body. The partition wall 11 may be configured including a partition wall main body 12 extending along a left-right direction of the vehicle 1, and a pair of side walls 13 extending from left-right direction both end portions of the wall main body along a forward direction and a rearward direction of the vehicle 1. The method of manufacturing the partition wall 11 is not particularly limited and the partition wall 11 may, for example, be manufactured by casting.

In the partition wall 11 described above, a mounting hole 14 for mounting an air conditioning unit or the like may be formed at a substantially central portion in the partition wall main body 12, and one each of through holes 15A, 15B may formed at positions adjacent to the respective left-right direction end portions of the partition wall main body 12 for routing of the wiring 40, described later. The mounting hole 14 and the through holes 15A, 15B may each be configured as holes penetrating the partition wall main body 12 in the front-rear direction. Moreover, a partially curved profile may be adopted for the pair of side walls 13 to match a layout of other configuration elements (wheels, for example) of the vehicle 1.

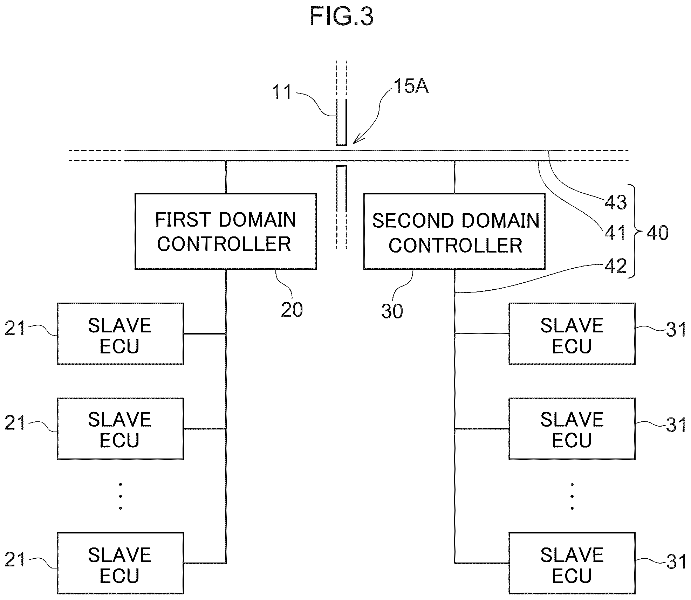

Fig. 3 is a block diagram schematically illustrating a connection structure of first and second domain controllers. The first and second domain controllers 20, 30 are installed to the vehicle 1 and may be connected to plural respective slave ECUs 21, 31 over an onboard communication network such as, for example, a controller area network (CAN) or a local interconnect network (LIN). Moreover, the first and second domain controllers 20, 30 may similarly be connected to each other. Note that part of a connection between the slave ECUs and the domain controllers may, for example, be by Ethernet or by wireless connection using a wireless communication standard such as Wi-Fi or Bluetooth.

Slave ECUs 21, 31 of the present exemplary embodiment are pre-classified into plural domains by control function thereof, with the slave ECUs 21, 31 belonging to each domain connected to the domain controller that manages that domain. The slave ECUs 21, 31 may contain a sensor ECU for detecting various information, an actuator ECU that performs or assists driving operations, and the like. The slave ECUs 21 are an example of "first electronic control units" and "electronic control units", and the slave ECUs 31 are an example of "second electronic control units" and "electronic control units".

Connections between the first domain controller 20, the second domain controller 30, and the plural slave ECUs 21, 31 may be achieved by employing a connection means such as the wiring 40, and in particular a communication bus 41, a communication cable 42, and the like. Note that although in Fig. 3, only the first and second domain controllers 20, 30 and plural slave ECUs 21, 31 connected to the first and second domain controllers 20, 30 are illustrated, the number of domain controllers, the connection structure of the slave ECUs, and the like is not limited to as illustrated in Fig. 3. For example, a non-illustrated gateway ECU for controlling the exchange of data may be connected to the communication bus 41.

In addition to the communication bus 41 and the communication cable 42 listed above, a power source cable 43 may also be included in the wiring 40 employed in the vehicle 1. In the present exemplary embodiment, an example is illustrated in which, from out of the wiring 40, the communication bus 41 and the power source cable 43 are routed so as to pass through the through hole 15A. Note that when the slave ECUs 21 connected to the first domain controller 20 are arranged on the cabin 2 side, and when the slave ECUs 31 connected to the second domain controller 30 are arranged in the vehicle front section 3, these connection wiring 40, for example the communication cable 42 too, is routed so as to pass through the through hole 15A.

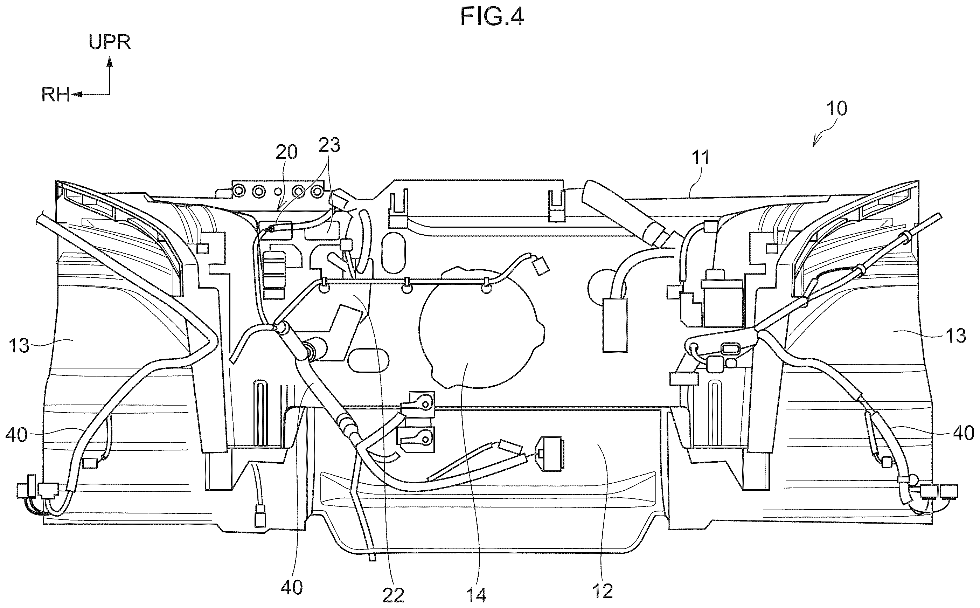

Fig. 4 is a diagram illustrating the cabin front structure illustrated in Fig. 2, as viewed from a vehicle front section side. The first domain controller 20 is, as illustrated in Fig. 4, mounted on the vehicle front section 3 side of the partition wall 11. The first domain controller 20 aggregates and connects the plural slave ECUs 21 together. The plural slave ECUs 21 may be configured to perform a prescribed control function, for example power source system control and air conditioning system control, or may be configured to perform body system control such as wiper control. The first domain controller 20 is configured by an ECU, and may function as a master ECU to perform integrated management of the plural slave ECUs 21.

Moreover, the first domain controller 20, is on the vehicle front section 3 side of the partition wall main body 12, and may be mounted at a position adjacent to the through hole 15A positioned on the right from out of the through holes 15A, 15B provided on the left and right of the partition wall main body 12. The mounting position of the first domain controller 20 described above faces a glove box or a front passenger seat inside the cabin 2. One reason that can be given as to why the first domain controller 20 is arranged at such a position is to facilitate securing an installation space for the first domain controller 20 better than at other positions on the partition wall main body 12, for example a position facing the driver's seat.

The first domain controller 20 may be configured including a controller main body 22, and plural connectors 23 provided to a face on the opposite side thereof to the face facing the partition wall 11. From out of these, the controller main body 22 is a substantially rectangular shaped member, as illustrated in Fig. 2, and includes configuration elements, for example a processor, memory, and the like, for implementing ECU functions. A fixing structure, for example a screw hole, adhesive coating face, or the like, for mounting the first domain controller 20 to the partition wall 11 may be provided at an appropriate location outside the controller main body 22.

One or more of the plural connectors 23 is electrically connected to the wiring 40. In order to connect to the wiring 40, the corresponding connector 23 is preferably provided to the face on the opposite side of the controller main body 22 to the face facing the partition wall 11. A routing distance of the wiring 40 from the above position where the connector 23 is provided to where the wiring 40 is pulled out to the vehicle front section 3 side through the through hole 15A is preferably suppressed to a short distance. Note that from out of the connectors 23, there is no particular limitation to the positions of those connectors 23 not connected to the wiring 40 routed so as to pass through the through hole 15A. This means that, for example, a connector 23 to which the communication cable 42 extending from a given slave ECU 21 installed to the vehicle front section 3 is connected may be provided at a position comparatively distanced from the through hole 15A.

Note that although the first domain controller 20 of the present exemplary embodiment performs control of a body system as described above, there is no limitation to there being one domain controller to perform control of the body system. Specifically, for example, in order to manage non-illustrated slave ECUs that perform control of configuration elements separated from the vehicle front section 3, such as control of door locks or power windows, third domain controllers 50A, 50B connected to these slave ECUs may also be further included. The third domain controllers 50A, 50B may, for example, be mounted to the pair of side walls 13. In this manner, the wiring length of the wiring needed can be shortened as long as the number and placement of domain controllers is adjusted to match the control target of the slave ECUs. Moreover, a control function to manage the first domain controller 20 is not limited to the above body system control function, and the function managed by the above second domain controller 30, described later, may be a function other than a driving assist function.

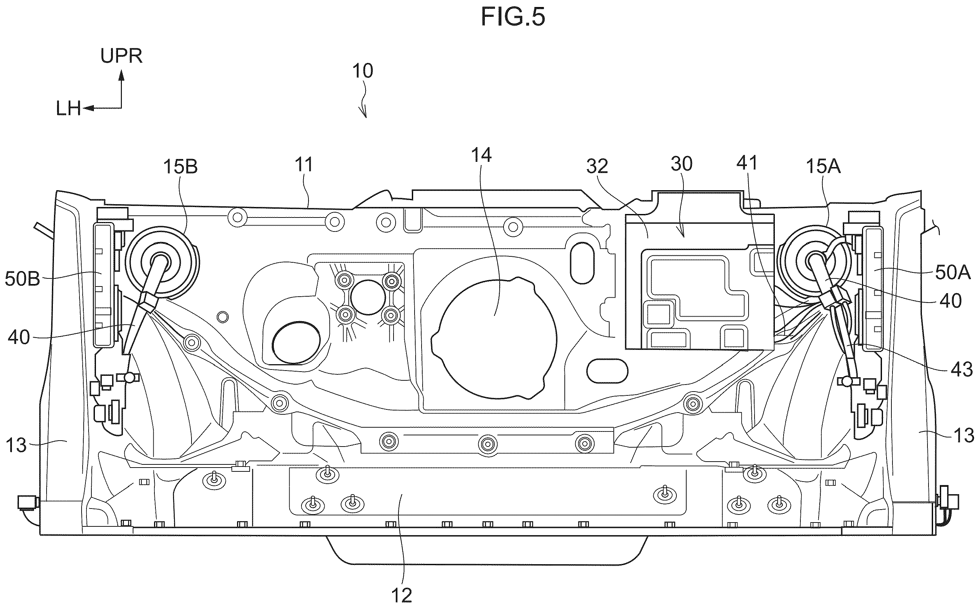

Fig. 5 is a diagram illustrating the cabin front structure illustrated in Fig. 2, as viewed from the cabin side. Note that arrow LH illustrated in Fig. 5 indicates a left direction of the vehicle 1. The second domain controller 30 is mounted to the cabin 2 side of the partition wall 11, as illustrated in Fig. 5. The second domain controller 30 aggregates and is connected to the plural slave ECUs 31. The plural slave ECUs 31 have a control function different to that of the slave ECUs 21, and more specifically are, for example, ECUs to implement a driving assist function that is a function related to advance driver assistance system (ADAS) and autonomous driving (AD), or related to connected car (CC). In the present exemplary embodiment, an example is given of the second domain controller 30 for a domain controller that manages a domain related to ADAS (sometimes referred to as an ADAS-ECU or an ADAS-domain control unit (DCU)). Examples of slave ECUs 31 to implement ADAS include, for example, ECUs that perform control of an onboard camera and control of radar/LiDAR, and control of various meters. The second domain controller 30 is configured by an ECU, and may function as a master ECU that performs integrated management of the plural slave ECUs 31.

Moreover, the second domain controller 30 is on the cabin 2 side of the partition wall main body 12 and, similarly to the first domain controller 20 described above, may be mounted at a position adjacent to the through hole 15A of the partition wall main body 12. Note that relative positions of the first and second domain controllers 20, 30 are described later.

A specific configuration of the second domain controller 30 is broadly similar to that of the first domain controller 20. Namely, the second domain controller 30 may include a controller main body 32, and plural connectors 33. However, the plural connectors 33 include at least a connector 33 to which the wiring 40 routed so as to pass through the through hole 15A is connected, provided on a face of the controller main body 32 adjacent to the through hole 15A. Note that although in the present exemplary embodiment an example is given in which the connectors 23, 33 to which the wiring 40 is connected are provided to the respective faces of the controller main bodies 22, 32 on the opposite side to the faces facing the partition wall main body 12, or are provided to faces adjacent to the through hole 15A, the placement thereof may be modified as appropriate as long as they are positioned comparatively near to the through hole 15A.

The first domain controller 20 and the second domain controller 30 equipped with the above configurations are electrically connected together by the wiring 40 routed so as to pass through the through hole 15A. This means that the wiring length of the wiring 40 for connecting the first domain controller 20 and the second domain controller 30 together can be suppressed to a short length when the distance between the first domain controller 20 and the second domain controller 30 is close. If the wiring length of the wiring 40 is made shorter then not only does this enable a cost reduction to be achieved due enabling to the wiring 40 needed for connection to be shorter, but the weight of the vehicle 1 can also be suppressed. In consideration of these points, the first domain controller 20 and the second domain controller 30 of the present exemplary embodiment are arranged such that at least a part thereof overlaps when looking in a vehicle forward direction. Note that "when looking in a vehicle forward direction" indicates, for example, a field of view when looking in a vehicle forward direction from inside the cabin.

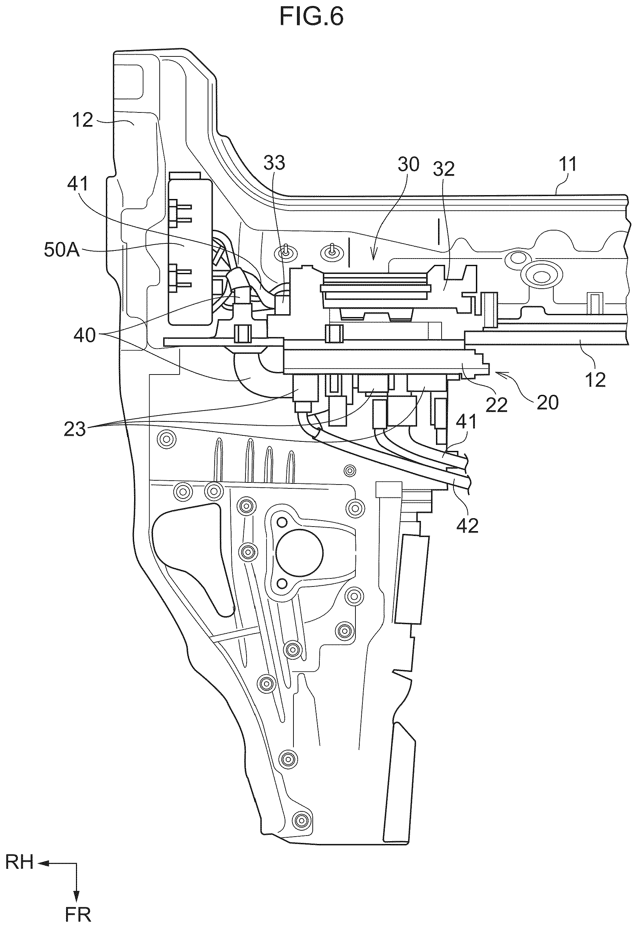

Fig. 6 is an enlargement illustrating part of the cabin front structure of Fig. 2, more specifically a right side portion thereof, as viewed from above. The first domain controller 20 and the second domain controller 30 are, as illustrated in Fig. 2 and Fig. 6, installed so as to face each other across the partition wall main body 12. The degree to which the first domain controller 20 and the second domain controller 30 overlap with each other is not particularly limited due to depending on the size and shape of each of the domain controllers. As an example, the relative positions of the first domain controller 20 and the second domain controller 30 may be adjusted such that at least 30% of the surface area of one of the domain controllers overlaps with the other domain controller when looking in a vehicle forward direction, with at least 50% being preferable therefor, and at least 80% being more preferable therefor.

As described above, the first domain controller 20 mounted in the vehicle front section 3 and the second domain controller 30 mounted in the cabin 2 are installed partitioned from each other across the partition wall main body 12 and overlap with each other when looking in the vehicle forward direction, resulting in a distance between the two domain controllers being close, and enabling the wiring length of the wiring 40 for connecting them both together to be suppressed to a short length. In the present exemplary embodiment, at least one out of the first domain controller 20 or the second domain controller 30 is mounted at a position adjacent to the through hole 15A provided in the partition wall 11 in order to make the wiring length of the above wiring 40 shorter. When the first domain controller 20 and the second domain controller 30 are arranged in such a manner, the wiring length of the wiring 40 for connecting to the connectors 23, 33 of the first and second domain controllers 20, 30 through the through hole 15A can be made short.

In addition thereto, in the present exemplary embodiment, the connectors 23, 33 to which the wiring 40 is connected are respectively installed to a face adjacent to the through hole 15A, or to a face on the opposite side to the face facing the partition wall 11, in order to make a shorter wiring length of the wiring 40 from where it passes through the through hole 15A to where it is connected to the connectors 23, 33 of the first and second domain controllers 20, 30.

As described above, the integrated electronic control unit, the cabin front structure 10, and the vehicle 1 according to the present exemplary embodiment enables a shorter wiring length of the wiring connecting two domain controllers together by arranging the plural domain controllers close together.

In the exemplary embodiment described above, the reason that the first domain controller 20 was selected as being a domain controller that manages slave ECUs 21 performing body system control, and the second domain controller 30 was selected as being a domain controller that manages slave ECUs 31 performing ADAS control, is that the placement of each of the slave ECUs 21, 31 results therefrom. In other words, consideration is given to the fact that slave ECUs 31 that perform ADAS control are often placed on the cabin 2 side, and slave ECUs 21 that perform body system control are often placed on the vehicle front section 3 side. Setting each of the domain controllers as described above also enables a shorter wiring length of the wiring between the slave ECUs and the domain controller.

Moreover, in the exemplary embodiment described above an example is given of the vehicle front section 3 as an example of a drive section, however, for example in cases in which an engine room or a battery housing area is positioned at the rear of the vehicle 1, then the structure described above may be adopted for between a vehicle rear section and a cabin.

The present disclosure is not limited to the exemplary embodiment described above, and various modifications may be implemented within a range not departing from the spirit of the present disclosure. All such modifications are included in the technical idea of the present disclosure. Moreover, unless explicitly stated otherwise in the specification, each of the configuration elements of the present disclosure are not limited to being a single thereof, and there may be plural thereof present.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the disclosure (especially in the context of the following claims) is to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the disclosure and does not pose a limitation on the scope of the disclosure unless otherwise claimed. No language in the specification should be construed as indicating any non-claimed element as essential to the practice of the disclosure.

Preferred embodiments of this disclosure are described herein, including the best mode known to the inventors for carrying out the disclosure. Variations of those preferred embodiments may become apparent to those of ordinary skill in the art upon reading the foregoing description. The inventors expect skilled artisans to employ such variations as appropriate, and the inventors intend for the disclosure to be practiced otherwise than as specifically described herein. Accordingly, this disclosure includes all modifications and equivalents of the subject matter recited in the claims appended hereto as permitted by applicable law. Moreover, any combination of the above-described elements in all possible variations thereof is encompassed by the disclosure unless otherwise indicated herein or otherwise clearly contradicted by context.

## Claims

1. An integrated electronic control unit (20), wherein:
the integrated electronic control unit is installed at a vehicle (1), aggregates and is connected by control function to a plurality of electronic control units(21) installed at the vehicle, and is mounted to a partition wall (11) positioned between a cabin (2) and a drive section (3) of the vehicle so as to face another integrated electronic control unit (30) across the partition wall, and such that at least a part of the integrated electronic control unit overlaps with the other integrated electronic control unit when viewed in a vehicle forward direction.

2. The integrated electronic control unit of claim 1, wherein the integrated electronic control unit is mounted at a position adjacent to a through hole (15A) provided in the partition wall through which wiring (40) is routed.

3. The integrated electronic control unit of claim 1 or 2, comprising:
a controller main body(22); and
a connector (23) provided at a face of the controller main body adjacent to a through hole(15A) provided in the partition wall through which wiring (40) is routed, or provided at a face of the controller main body on an opposite side from a face facing the partition wall, the wiring being connected to the connector.

4. An integrated electronic control unit mounting structure comprising:
a partition wall (11) that is positioned between a cabin (2) and a drive section (3) of a vehicle (1);
a first integrated electronic control unit (20) that is mounted to the drive section side of the partition wall, and that aggregates and is connected to a plurality of first electronic control units (21) installed at the vehicle and having a prescribed control function; and
a second integrated electronic control unit (30) that is mounted to a cabin side of the partition wall, and that aggregates and is connected to a plurality of second electronic control units (31) installed at the vehicle and having another prescribed control function that is different from the prescribed control function,
wherein the first integrated electronic control unit and the second integrated electronic control unit are respectively mounted to the partition wall such that at least part of the integrated electronic control units overlap when viewed in a vehicle forward direction.

5. The integrated electronic control unit mounting structure of claim 4, wherein at least one of the first integrated electronic control unit or the second integrated electronic control unit is mounted at a position adjacent to a through hole (15A) provided in the partition wall through which wiring (40) is routed.

6. The integrated electronic control unit mounting structure of claim 4 or 5, wherein the first integrated electronic control unit and the second integrated electronic control unit each comprise:
a controller main body (22, 32); and
a connector(23, 33) provided at a face of the controller main body adjacent to a through hole (15A) provided in the partition wall through which wiring (40) is routed, or provided at a face of the controller main body on an opposite side from a face facing the partition wall, the wiring being connected to the connector.

7. The integrated electronic control unit mounting structure of any one of claims 4 to 6, wherein the other prescribed control function includes a driving assist function, and the prescribed control function includes a function other than the driving assist function.

8. A vehicle (1) comprising:
a partition wall (11) that is positioned between a cabin (2) and a drive section (3);
a first integrated electronic control unit (20) that is mounted to the drive section side of the partition wall, and that aggregates and is connected to a plurality of first electronic control units (21) having a prescribed control function; and
a second integrated electronic control unit (30) that is mounted to a cabin side of the partition wall, and that aggregates and is connected to a plurality of second electronic control units (31) having another prescribed control function that is different from the prescribed control function,
wherein the first integrated electronic control unit and the second integrated electronic control unit are respectively mounted to the partition wall such that at least part of the integrated electronic control units overlap when viewed in a vehicle forward direction.
